Europäisches Patentamt

(19) European Patent Office

Office européen des brevets

(11) **EP 0 726 645 A2**

## (12) EUROPEAN PATENT APPLICATION

(43) Date of publication:
14.08.1996 Bulletin 1996/33

(51) Int. Cl.$^6$: **H02P 7/628**, H02P 21/00

(21) Application number: **96105889.8**

(22) Date of filing: **15.09.1994**

(84) Designated Contracting States:
**DE GB IT**

(30) Priority: **17.09.1993 JP 230648/93**
**11.05.1994 JP 97089/94**

(62) Application number of the earlier application in accordance with Art. 76 EPC: **94114548.4**

(71) Applicant: **FUJI ELECTRIC CO. LTD.**
**Kawasaki 210 (JP)**

(72) Inventors:
• **Tajima, Hirokazu,**
c/o Fuji Electric Co., Ltd.
**Kawasaki 210 (JP)**

• **Umida, Hidetoshi,**
c/o Fuji Electric Co., Ltd.
**Kawasaki 210 (JP)**

(74) Representative: **Hoffmann, Eckart, Dipl.-Ing.**
**Patentanwalt,**
**Bahnhofstrasse 103**
**82166 Gräfelfing (DE)**

Remarks:
This application was filed on 15 - 04 - 1996 as a divisional application to the application mentioned under INID code 62.

### (54) Control method and apparatus for AC motor

(57) A control method and apparatus for an AC motor (6) are described in which a voltage drop across the primary of the motor is estimated by using an estimated resistance value $R_1^{\#}$, estimated by an integral or proportional plus integral operation on the deviation between a detected magnetizing current value $I_M$ and a reference magnetizing current value $I_M^*$, in place of an actual primary resistance value $R_1$. The time for the estimated resistance value $R_1^{\#}$ to reach the true primary resistance value is reduced by means of a varying reference magnetizing current value $I_M^{**}$.

FIG. 5

## Description

The present invention relates to a control method and apparatus for an AC motor that detects a primary resistance of the AC motor with excellent accuracy.

Magnetic flux and torque of an AC motor can be controlled by resolving a current flowing through the AC motor into a magnetizing current component parallel to the magnetic flux and a torque current component perpendicular to the magnetic flux, and by controlling the magnetizing current and the torque current components independently. It is well known that the speed of the AC motor can be controlled highly accurately by the so-called transvector control method that treats the current of the AC motor as a vector consisting of two components.

Since, in the transvector control of the AC motor, the AC motor is controlled by using an equivalent circuit of the AC motor as a control model, control constants based on the equivalent circuit constants are pre-set to a control apparatus. Usually, designed values of the motor constants are used as these control constants. However, there are differences between the designed and actual values of the motor constants and the differences cause control errors. Variations of the motor constants during driving the motor also cause control errors. Furthermore, the transvector control method can not be applied when the constants of the motor already in service are unknown.

In the transvector control, it is necessary to detect the induced electromotive force which relates to the magnetic flux. The induced electromotive force is calculated by subtracting the voltage drop across the internal impedance of the motor from the terminal voltage of the motor. The voltage drop across the internal impedance of the motor is obtained by multiplying the magnetizing current component and a primary resistance value of the motor. Generated torque becomes insufficient especially when the motor is driven at low speed, because an appropriate output reference voltage value can not be calculated when the primary resistance value is different from the pre-set value. To solve this problem, a method has been proposed that obtains the primary resistance value by dividing an output voltage by a phase current of predetermined value which is made to flow through the motor (See RM-85-26, Technical Meeting Paper on Rotating Machine, p. 65, Institute of Electrical Engineers of Japan).

The method of calculating the primary resistance value by dividing output voltage by the phase current according to the prior art requires high precision detectors, because the prior art method is affected by the precision of the voltage and current detectors. However, since the primary resistance value of a large capacity motor is small, even the high precision detectors would not improve accuracy of the measurements. Moreover, in the transient period, induced electromotive force of the magnetizing inductance is added to the voltage drop across the primary resistance. Since decay time of the induced electromotive force is prolonged in an AC motor of large secondary time constant, for example a large capacity AC motor, it takes long time for the resistance value obtained by dividing output voltage by a current to reach a true primary resistance value. Besides, motor windings through which a current flows or semiconductor switching elements of the power converter are different depending on a phase angle of voltage applied to the AC motor. Since resistance values of the motor windings or the semiconductor switching elements show variations, the measured primary resistance value shows variation depending on phase angle difference which further causes a control error. In controlling the general-purpose AC motors, actual torque is not always used for further control of the AC motors.

A method and an apparatus according to the pre-characterizing portions of claim 1 and 2, respectively, are disclosed in EP-A-0 500 121.

In view of the foregoing, an object of the present invention is to provide a control method and apparatus that measures, without using high precision detectors, the primary resistance of an AC motor with high accuracy in a short time by eliminating the errors caused by the phase angle difference.

Another object of the present invention is to provide a control method and apparatus that detects malfunctions such as breaking of wiring, open phases and three-phase unbalance of the AC motor or the power converting means.

These objects are achieved with a control method and a control apparatus, respectively, as claimed.

The control method according to the invention obtains an estimated primary resistance $R_1^{\#}$ as a result of an integral operation or a proportional plus integral operation on the difference between a reference magnetizing current value $I_M^*$ and a detected magnetizing current value $I_M$. The voltage drop across the primary resistance is estimated by multiplying the estimated primary resistance value $R_1^{\#}$ and the reference magnetizing current value $I_M^*$. A reference magnetizing voltage value $V_M^*$ is obtained by adding an amplified deviation of the reference magnetizing current value $I_M^*$ from the detected magnetizing current value $I_M$ and the estimated voltage drop value. The reference magnetizing voltage value $V_M^*$ is expressed by the following equation 1. The estimated primary resistance $R_1^{\#}$ is expressed by the following equation 2 or 3. In these equations, $K_A$ is a proportional gain of an amplifying means, $K_P$ a proportional gain of a proportional plus integral means, and $K_I$ an integral gain of an integral means or the proportional plus integral means.

$$V_M^* = K_A(I_M^* - I_M) + R_1^{\#} \cdot I_M^* \qquad (1)$$

$$R_1^{\#} = K_I \int (I_M^* - I_M) \cdot dt \qquad (2)$$

$$R_1^{\#} = K_P(I_M^* - I_M) + K_I \int (I_M^* - I_M) \cdot dt \qquad (3)$$

In a steady state, the following equation 4 holds.

$$I_M = V_M^*/R_1 \qquad (4)$$

The following equation 5 is obtained from equations 1 and 4.

$$I_M = \frac{K_A + R_1^{\#}}{K_A + R_1} \cdot I_M^* \qquad (5)$$

Since, in equations 2 and 3, the estimated primary resistance value $R_1^{\#}$ increases when the deviation between the reference and detected magnetizing current values$(I_M^*-I_M)$ is positive and $R_1^{\#}$ decreases when the deviation $(I_M^*-I_M)$ is negative, the reference magnetizing voltage value $V_M^*$ is corrected by equation 1. Therefore, when the deviation $(I_M^*-I_M)$ decreases to zero, the estimated primary resistance value $R_1^{\#}$ coincides with the actual primary resistance value $R_1$ from equation 5.

As described earlier, since the decay time of the induced electromotive force is prolonged in an AC motor of large secondary time constant, for example a large capacity AC motor, it takes long time for the resistance value obtained by dividing output voltage by a current to reach a true primary resistance value. To solve this problem, the control method according to the invention determines in advance a reference magnetizing current pattern in which the reference magnetizing current value $I_M^*$ decreases from an initial large value at the start of the AC motor to a predetermined value after a predetermined period of time has elapsed. As a result of this, the necessary time for estimating the primary resistance value is shortened, because an actual magnetizing current takes a large value immediately after the start of the AC motor, by which influence of the induced electromagnetic force on the voltage drop across the primary resistance is reduced.

Now the present invention will be described in detail hereinafter with reference to the accompanied drawings which illustrate preferred embodiments of the present invention.

Fig. 1 is a circuit block diagram of a control apparatus for an AC motor;

Fig. 2 is a circuit block diagram showing a modification of the apparatus of Fig. 1;

Fig. 3 is a circuit block diagram showing an embodiment of the present invention;

Fig. 4 is a graph showing the first variation example of an output from the current pattern generator 21 of Fig. 3;

Fig. 5 is a graph showing the second variation example of an output from the current pattern generator 21 of Fig. 3; and

Fig. 6 is a graph showing the third variation example of an output from the current pattern generator 21 of Fig. 3.

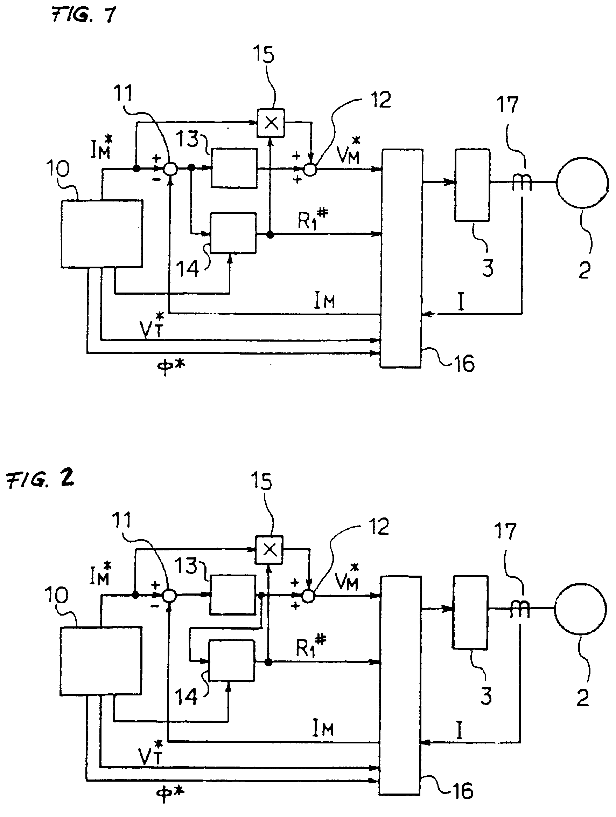

Figure 1 is a circuit block diagram showing a control apparatus for an AC motor. In the figure, a current detector 17 detects a current flowing from a power converter 3 to an AC motor 2. A voltage current control circuit 16 resolves the detected current value I into a detected magnetizing current value $I_M$ and a detected torque current value $I_T$ orthogonal to each other. Since the torque current value $I_T$ and a reference torque voltage value $V_T^*$ do not relate to the present invention, their explanations are omitted.

An adder 11 calculates the deviation of a reference magnetizing current value $I_M^*$ output from a reference value generator circuit 10 and the detected magnetizing current value $I_M$, and outputs the calculated deviation to an amplifier circuit 13 and a regulator circuit 14 comprised of an integral or a proportional plus integral circuit. Since the estimated primary resistance value $R_1^{\#}$ coincides with the actual primary resistance value $R_1$ when the deviation of the reference magnetizing current value $I_M^*$ from the detected magnetizing current value $I_M$ is zero, $I_M^*=I_M$, as equation 5 expresses, the regulator circuit 14 outputs the estimated primary resistance value $R_1^{\#}$, which becomes identical to the actual primary resistance value $R_1$. A multiplier 15 multiplies the thus obtained estimated primary resistance value $R_1^{\#}$ and the reference magnetizing current value $I_M^*$ to obtain the voltage drop across the primary resistance. A reference magnetizing voltage value $V_M^*$ is obtained, as equation 1 expresses, by adding in an adder 12 the voltage drop and the output from the amplifier circuit 13. The reference torque voltage value $V_T^*$ is also used for controlling the power converter 3 through the voltage current control circuit 16. In Fig. 1, $\phi^*$ designates a reference phase value.

Figure 2 is a circuit block diagram showing a modification of the apparatus of Fig. 1. In the apparatus of Fig. 2, the circuit is configured similarly to that of Fig. 1 except that the output signal from the amplifier circuit 13 is fed to the regulator circuit 14 comprised of an integral circuit or a proportional plus integral circuit. As Fig. 2 shows, the same effect is obtained irrespective of whether the input signal to the regulator circuit 14 is the calculation result of the adder 11 or the amplified calculation result of the adder 11 amplified through the amplifier circuit 13.

The control methods explained above obtain the estimated primary resistance value $R_1^{\#}$ based on the difference between the detected magnetizing current value $I_M$ and the reference magnetizing current value $I_M^*$. Since, according to the prior art, the primary resistance value is obtained directly from the current and voltage drop, precision of the detectors have affected the measured values and improvement of the detector precision has not contributed to the accuracy improvement of the measured values in the case of large capacity AC motors. The present control method facilitates estimating the primary resistance value $R_1^\#$ at any time without being affected by the detector precision even when the resistance value varies with temperature rise. The present control method also facilitates compensating wiring resistance between the power converting means and the AC motor or the voltage drop across the switching elements. The present control method is effective for safely estimating the primary resistance because the present control method simultaneously conducts current control.

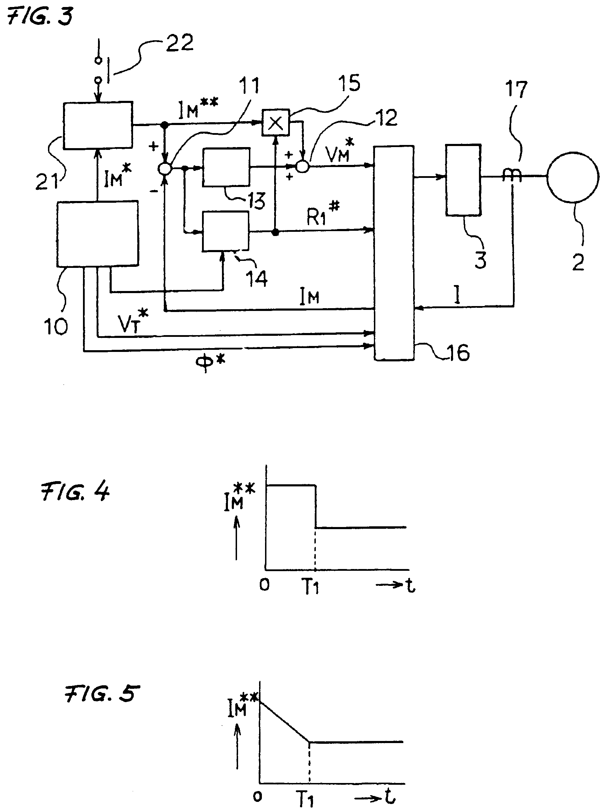

Figure 3 is a circuit block diagram showing an embodiment of the invention. In the embodiment of Fig. 3, names, functions and applications of the AC motor 2, power converter 3, reference value generator circuit 10, adders 11 and 12, amplifier circuit 13, regulator circuit 14, multiplier 15, voltage current control circuit 15 and current detector 17 are all the same with those in the apparatus of Fig. 1, and their explanations are omitted.

The embodiment of Fig. 3 is different from the apparatus of Fig. 1 in that the embodiment of Fig. 3 converts the reference magnetizing current value $I_M^*$ output from the reference value generator circuit 10 through a current pattern generator 21 to a varying reference magnetizing current value $I_M^{**}$, and that an operation command switch 22 is incorporated. Though the calculation result of the adder 11 is input to the regulator circuit 14 in Fig. 3 similarly as in the apparatus of Fig. 1, the amplified result of the amplifier 13, that amplifies the calculation result of the adder 11, may be input to the regulator circuit 14 in the same way as in the apparatus of Fig. 2.

As described earlier, it takes long time for the estimated resistance value of a large capacity AC motor estimated by dividing the output voltage by a current to reach the true primary resistance value, because the decay time of the induced electromotive force is prolonged because of the large secondary time constant of the large capacity AC motor. To solve this problem, the embodiment of Fig. 3 inputs a start command which indicates start point of the AC motor 2 to the current pattern generator 21 through the operation command switch 22. The current pattern generator 21 outputs, in response to the input start command, the varying reference magnetizing current value $I_M^{**}$ decreasing according to the current pattern from the initial large value to a predetermined value after a predetermined period of time has elapsed and shortens the time for the estimated resistance value to reach the true primary resistance value.

Figure 4 is a graph showing a first example of an output variation of the current pattern generator 21 of Fig. 3. In Fig. 4, the abscissa represents time and the ordinate the varying reference magnetizing current value $I_M^{**}$. $I_M^{**}$ takes a large value at the zero point of time when the AC motor 2 starts and decreases to a predetermined value at T1 when a predetermined time has elapsed.

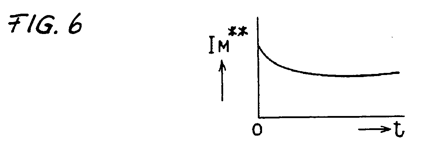

Figure 5 is a graph showing a second example of an output variation of the current pattern generator 21 of Fig. 3. In Fig. 5, the abscissa represents time and the ordinate the varying reference magnetizing current value $I_M^{**}$. $I_M^{**}$ takes a large value at the zero point of time when the AC motor 2 starts, decreases linearly with elapse of time and reaches the predetermined value at T1 when a predetermined time has elapsed.

Figure 6 is a graph showing a third example of an output variation of the current pattern generator 21 of Fig. 3. In Fig. 6, the abscissa represents time and the ordinate the varying reference magnetizing current value $I_M^{**}$. $I_M^{**}$ decreases exponentially with elapse of time from the initial large value at the time when the AC motor 2 starts and finally reaches the predetermined value.

As explained, this embodiment varies the reference magnetizing current value by means of the current pattern generator to reduce the effect of induced electromotive force of the motor which affects estimation of the primary resistance value at the start of the motor, facilitates estimating the primary resistance value in a short time even if the motor is of large capacity, the secondary time constant of which is large.

**Claims**

1. A method of controlling an AC motor, comprising the steps of:

    (a) resolving a detected value of a current flowing through said AC motor into a magnetizing current component ($I_M$) parallel to a magnetic flux and a torque current component perpendicular to said magnetic flux,

    (b) obtaining the deviation of said magnetizing current component ($I_M$) from a reference magnetizing current value ($I_M^*$),

    (c) executing a control operation for equalizing said magnetizing current component ($I_M$) to said reference magnetizing current value ($I_M^*$),

    (d) obtaining an estimated resistance value ($R_1^\#$) from an integral operation or from a proportional plus integral operation on said deviation of said magnetizing current component ($I_M$) from said reference magnetizing current value ($I_M^*$);

    (e) obtaining an estimated voltage drop across said primary resistance by multiplying said estimated resistance value ($R_1^\#$) and said reference magnetizing current value ($I_M^*$); and

    (f) obtaining a reference magnetizing voltage value ($V_M^*$) by adding said estimated voltage drop and said value corresponding to said deviation; and

    (g) driving said AC motor at a desired speed with AC electric power output from a power converter (3) controlled with said reference magnetizing voltage value and a reference torque voltage value,

said control method being **characterized by** the further step of:

varying said reference magnetizing current value ($I_M$*) from an initial large value to a predetermined smaller value within a predetermined period of time beginning at the start of said AC motor.

2. A control apparatus for an AC motor (2), comprising:

means (16) for resolving a detected value of a current flowing through said AC motor into a magnetizing current component ($I_M$) parallel to a magnetic flux and a torque current component perpendicular to said magnetic flux,

means (11) for obtaining the deviation of said magnetizing current component ($I_M$) from a reference magnetizing current value ($I_M$*),

means (13, 16) for executing a control operation for equalizing said magnetizing current component ($I_M$) to said reference magnetizing current value ($I_M$*),

means (14) for obtaining an estimated resistance value ($R_1^\#$) from an integral operation or from a proportional plus integral operation on said deviation of said magnetizing current component ($I_M$) from said reference magnetizing current value ($I_M$*);

means (15) for obtaining an estimated voltage drop across said primary resistance by multiplying said estimated resistance value ($R_1^\#$) and said reference magnetizing current value ($I_M$*); and

means (12) for obtaining said reference magnetizing voltage value ($V_M$*) by adding said estimated voltage drop and a value corresponding to said deviation, and

means (10) for driving said AC motor (2) at a desired speed with AC electric power output from a power converter (3) controlled with said reference magnetizing voltage value ($V_M$*) and a reference torque voltage value ($V_T$*), said apparatus being **characterized by** comprising:

means (21, 22) for varying said reference magnetizing current value ($I_M$*) from an initial large value to a predetermined smaller value within a predetermined period of time beginning at the start of said AC motor (2).

**$FIG.\ 7$**

**$FIG.\ 2$**

FIG. 3

FIG. 4

FIG. 5

FIG. 6